# EUROPEAN PATENT APPLICATION

(11) **EP 4 693 388 A1**
(43) Date of publication of application: **11.02.2026**
(21) Application number: 25192101.1
(22) Date of filing: 28.07.2025
(51) Int. Cl.: H01L 21/768, H01L 23/528, H10D 30/47, H10D 30/01, H10D 64/23

(54) **SEMICONDUCTOR DEVICE INCLUDING BURIED BACKSIDE ISOLATION STRUCTURE AND SELF-ALIGNED BACKSIDE CONTACT STRUCTURE AND MANUFACTURING THE SAME**

(30) Priority: 05.08.2024 US 202463679478 P; 28.02.2025 US 202519067247
(71) Applicant: SAMSUNG ELECTRONICS CO., LTD., Yeongtong-gu Suwon-si, Gyeonggi-do 16677 (KR)
(72) Inventor: JANG, Sangshin, San Jose, CA, 95134 (US); CHUNG, Wonkeun, San Jose, CA, 95134 (US); KIM, Byounghoon, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device including: a channel structure; a gate structure on the channel structure; a backside isolation structure on the gate structure; an alignment spacer layer on a lower side surface of the backside isolation structure, the alignment spacer layer comprising a material different from the backside isolation structure; a source/drain pattern on the channel structure; and a backside contact structure on the source/drain pattern.

## Description

### BACKGROUND

### 1. Field

Apparatuses and methods consistent with example embodiments of the disclosure relate to a semiconductor device in which a backside contact structure is formed along with a buried backside isolation structure.

### 2. Description of Related Art

The backside power delivery network (BSPDN) for a semiconductor device has been introduced due to its advantages in area reduction and performance improvement for the semiconductor device. The BSPDN is formed on a back side of a semiconductor device, and may include buried power rails and backside contact structures connecting source/drain patterns of the semiconductor device to the power rails. However, a complicated process on the back side of the semiconductor device with a very small process margin prevents precise alignment (or overlay) of a backside contact structure with a selected source/drain region through a backside etching process.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor device including a backside isolation structure and a backside contact structure formed in a self-aligned manner based on an alignment spacer layer on a lower side surface of the backside isolation structure.

According to one or more embodiments, there is provided a semiconductor device which may include: a channel structure; a gate structure on the channel structure; a backside isolation structure on the gate structure; an alignment spacer layer on a lower side surface of the backside isolation structure, the alignment spacer layer comprising a material different from a material of the backside isolation structure; a source/drain pattern on the channel structure; and a backside contact structure on the source/drain pattern.

According to one or more embodiments, there is provided a semiconductor device which may include: a channel structure; a gate structure on the channel structure; a backside isolation structure on the gate structure; a 1^{st} source/drain pattern and a 2^{nd} source/drain pattern on the channel structure; and a backside contact structure of which a 1^{st} portion is provided at a 1^{st} side of the backside isolation structure, below the 1^{st} source/drain pattern, wherein a 2^{nd} portion of the backside contact structure is provided at a 2^{nd} side, opposite the 1^{st} side, of the backside isolation structure, below the 2^{nd} source/drain pattern, and wherein the 2^{nd} source/drain pattern is not connected to another backside contact structure.

According to one or more embodiments, there is provided a method of manufacturing a semiconductor device, which may include: forming a channel structure, a source/drain pattern on the channel structure, and a gate structure surrounding the channel structure; forming a backside isolation structure on the gate structure; forming an alignment spacer layer on a lower side surface of the backside isolation structure, the alignment spacer comprising a material different from a material of the backside isolation structure; and forming a backside contact structure on the source/drain pattern in a self-aligning manner based on the alignment spacer layer.

### BRIEF DESCRIPTION OF DRAWINGS

Example embodiments of the disclosure will be more clearly understood from the following detailed description taken in conjunction with the accompanying drawings in which.
FIGS. 1A to 1K illustrate a method of manufacturing a semiconductor device including a backside contact structure, according to one or more embodiments.
FIG. 2A illustrates an intermediate semiconductor device in which a recess to form a backside contact structure therein is misaligned with a selected source/drain pattern, according to one or more embodiments.
FIG. 2B illustrates the intermediate semiconductor device in which a backside contact structure is connected to a gate structure as well as the selected source/drain pattern, according to one or more embodiments.
FIGS. 3A to 3H illustrate a method of manufacturing a semiconductor device including a backside contact structure formed based on a self-aligned patterning operation, according to one or more embodiments.
FIG. 4A illustrates an intermediate semiconductor device in which a recess to form a backside contact structure therein is misaligned with a selected source/drain pattern, according to one or more embodiments.
FIG. 4B illustrates the intermediate semiconductor device in which a backside contact structure is connected to only the selected source/drain pattern without being connected to an adjacent gate structure, according to one or more embodiments.
FIG. 5 illustrates a flowchart of a method of manufacturing a semiconductor device including a backside contact structure formed based on a self-aligned patterning operation in reference to FIGS. 3A-3H, according to one or more embodiments.
FIG. 6 is a schematic block diagram illustrating an electronic device including at least one semiconductor device formed based on at least one of the semiconductor devices shown in FIGS. 1K and 3H, respectively, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of a semiconductor device including a nanosheet transistor, a forksheet transistor or a FinFET, and materials forming the same may or may not be described in detail herein. For example, a certain isolation layer or structure of a semiconductor device and materials forming the same may be omitted herein when this layer or structure is not related to the novel features of the embodiments or well known by the ordinary skilled persons in the art.

Provided herebelow are various embodiments of the disclosure directed to a semiconductor device including a backside contact structure and a backside isolation structure.

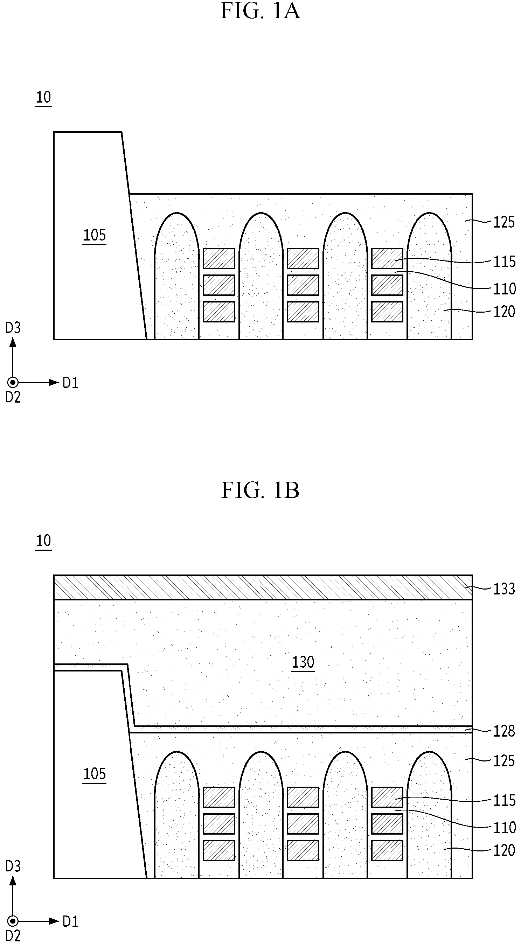

FIGS. 1A to 1K illustrate a method of manufacturing a semiconductor device including a backside contact structure, according to one or more embodiments.

Referring to FIG. 1A, an intermediate semiconductor device 10 may be provided in an upside-down form after a substrate is removed from a back side of the intermediate semiconductor device 10.

In the upside-down form of the intermediate semiconductor device 10, the back side of the intermediate semiconductor device 10, which may be a back side of a frontside isolation structure 125, may face upward in a D3 direction to facilitate formation of a BSPDN structure including a backside contact structure on the back side of the intermediate semiconductor device 10 in a later step. Thus, a front side of the intermediate semiconductor device 10 where front-end-of-line (FEOL) structures are formed is directed downward in the D3 direction in FIG. 1A.

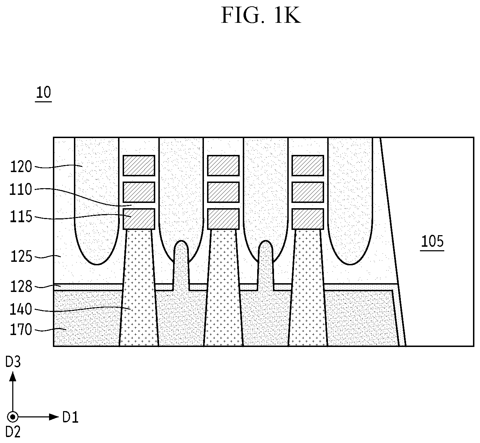

It is to be understood here that, as the intermediate semiconductor devices 10 shown in FIGS. 1A-1J are in an upside-down form, a top surface (portion) and a bottom surface (portion) of each of structural elements thereof may respectively refer to a bottom surface (portion) and a top surface (portion) of the structural element thereof before they are flipped or turned upside down or after they are completed as a semiconductor device shown in FIG. 1K.

The FEOL structures may include channel structures 110 extended in a D1 direction and surrounded by respective gate structures 115. Each of the channel structures 110 may be formed to connect source/drain patterns 120 at both sides thereof for current flow therebetween at control of a corresponding gate structure 115 surrounding the channel structure 110. Each of the channel structures 110 may be formed of a plurality of nanosheet layers arranged in the D3 direction, and thus, the channel structures 110, the gate structures 115 and the source/drain patterns 120 may form a plurality of nanosheet transistors of the intermediate semiconductor device 10.

Herein, the D1 direction refers to a channel length direction or active region length direction, intersecting a D2 direction which is referred to as a channel width direction or active region width direction. The D1 direction and the D2 direction both may be a horizontal direction intersecting the D3 direction which is a vertical direction.

The channel structures 110 may have been epitaxially grown from a silicon substrate, and may also be formed of silicon. The source/drain patterns 120 may have been epitaxially grown from the channel structures 110. The source/drain patterns 120 may be formed of silicon with n-type impurities (e.g., phosphorus, arsenic, or antimony) when the source/drain patterns 120 form an n-type field-effect transistor. In contrast, the source/drain patterns 120 may be formed of silicon germanium with p-type impurities (e.g., boron, gallium, or indium) when the source/drain patterns 120 form a p-type field-effect transisto ∘ r. The gate structures 115 may each be formed of a gate dielectric layer on the channel structure 110, a work-function metal layer on the gate dielectric layer, and a gate electrode on the work-function metal layer. The gate dielectric layer may include an interfacial layer formed of an oxide material such as silicon oxide (e.g., SiO, SiO2, etc.), not being limited thereto. The gate dielectric layer may also include a high-k layer formed of a high-k material such as hafnium (Hf), aluminum (Al), zirconium (Zr), lanthanum (La), magnesium (Mg), barium (Ba), titanium (Ti), lead (Pb), and/or a combination thereof, not being limited thereto. The work-function metal layer may be formed of a metal or metal alloy such as copper (Cu), aluminum (Al), titanium (Ti), tantalum (Ta), tungsten (W), cobalt (Co), TiN, WN, TiAl, TiAlN, TaN, TiC, TaC, TiAlC, TaCN, TaSiN, and/or a combination thereof, not being limited thereto. The gate electrode may be formed of a metal such as Cu, W, Al, ruthenium (Ru), molybdenum (Mo), and Co, not being limited thereto, or a metal alloy thereof.

The FEOL structures of the intermediate semiconductor device 10 may be surrounded by a frontside isolation structure 125. At a side of the intermediate semiconductor device 10 may be formed a shallow trench isolation (STI) structure 105 that isolates the intermediate semiconductor device 10 from an adjacent intermediate semiconductor device or semiconductor device. The frontside isolation structure 125 may be formed of a low-k dielectric material such as silicon oxide (SiO or SiO₂), silicon nitride (SiN or Si₃N₄), SiCH, SiCOH, etc., not being limited thereto. The STI structure 105 may be formed of silicon oxide (SiO or SiO₂), SiON, etc., which may be the same or different from the material forming the frontside isolation structure 125.

Referring to FIG. 1B, a 1^{st} liner 128 may be layered on a top surface of the intermediate semiconductor device 10 (that is, a bottom surface of the intermediate semiconductor device 10 prior to being flipped or turned upside down) including the STI structure 105 to protect these structures from a subsequent process including forming a 1^{st} masking structure 130 and a hard mask layer 133 thereon.

The 1^{st} liner 128 may be formed through, for example, depositing silicon nitride (SiN or Si₃N₄), SiOCN, etc. on top surfaces of the frontside isolation structure 125 and the STI structure 105 by atomic layer deposition (ALD), not being limited thereto. The 1^{st} masking structure 130 may be or include a spin-on-hard mask (SOH) which may be formed through, for example, depositing a carbon-based polymer or a silicon-containing polymer on the 1^{st} liner 128 by physical vapor deposition (PVD), chemical vapor deposition (CVD), plasma-enhanced CVD (PECVD), sputtering, and/or plating, not being limited thereto. According to one or more other embodiments, a different type of material may be used to form the 1^{st} masking structure 130. The hard mask layer 133 may be formed through, for example, depositing silicon nitride (SiN or Si₃N₄), SiCN, titanium oxide (TiO₂), etc. on the 1^{st} masking structure 130 by PVD, PECVD, ALD, etc., not being limited thereto.

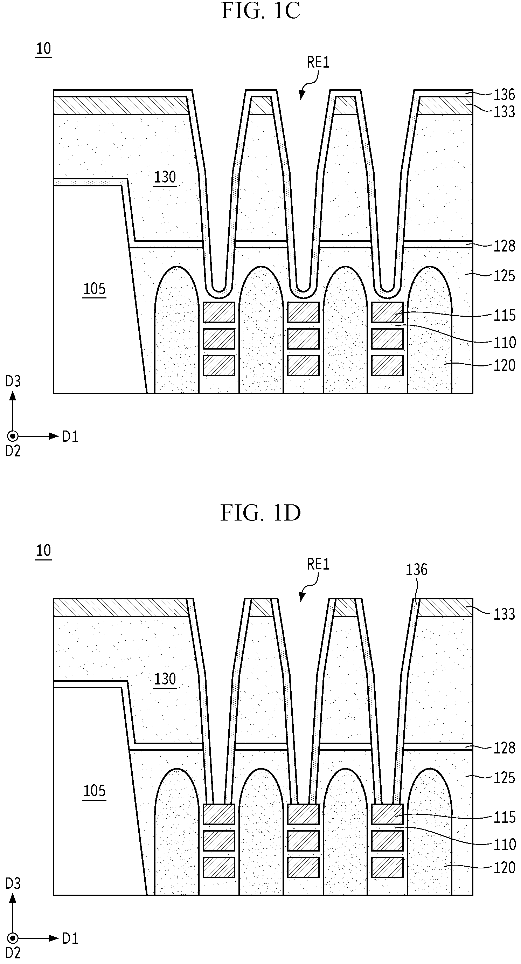

Referring to FIG. 1C, the 1^{st} masking structure 130 and the frontside isolation structure 125 therebelow may be patterned to form 1^{st} recesses RE1 in the frontside isolation structure 125 and the 1^{st} masking structure 130 above the gate structures 115, respectively, and a 2^{nd} liner 136 may be formed along an inner surface of each of the 1^{st} recesses RE1.

The 1^{st} masking structure 130 and the frontside isolation structure 125 may be vertically patterned to form the 1^{st} recesses RE1 therein at positions below which the gate structures 115 are formed based on the hard mask layer 133 through, for example, dry etching or wet etching, not being limited thereto. Photoresist patterns may be formed on the hard mask layer 133 for the patterning operation in this step. Further, the 2^{nd} liner 136 may be formed along the inner surface of each of the 1^{st} recesses RE1 and a top surface of the hard mask layer 133 through, for example, deposition of silicon nitride (SiN or Si₃N₄), SiOCN, etc., which may be the same as or different from that material forming the 1^{st} liner 128, by ALD, not being limited thereto.

Referring to FIG. 1D, the 1^{st} recesses RE1 formed in the 1^{st} masking structure 130 may be further etched to expose the gate structures 115 therebelow, and the hard mask layer 133 and a portion of the 2^{nd} liner 136 on the hard mask pattern 133 may be removed.

Dry etching or wet etching may be performed to extend the 1^{st} recesses RE1 downward by removing a bottom portion of the 2^{nd} liner 136 above each gate structure 115 so that a top surface of each of the gate structures 115, for example, a top surface of the work-function metal layer or the gate electrode of the gate structure 115, is exposed through each of the extended 1^{st} recesses RE1. At this time, the 2^{nd} liners 136 formed on side surface of the 1^{st} recesses RE1 may protect the frontside isolation structure 125 and the source/drain patterns 120 therein from the etching operation performed to expose the gate structure 115. Further, the hard mask layer 133 may be removed along with the 2^{nd} liner 136 thereon by ashing, stripping, selective etching, etc., not being limited thereto.

It is understood here that the top surface of each of the gate structures 115 exposed through each of the extended 1^{st} recesses RE1 may refer to a bottom surface thereof before and after the manufacturing process described herein in reference to FIGS. 1A to 1J as mentioned earlier.

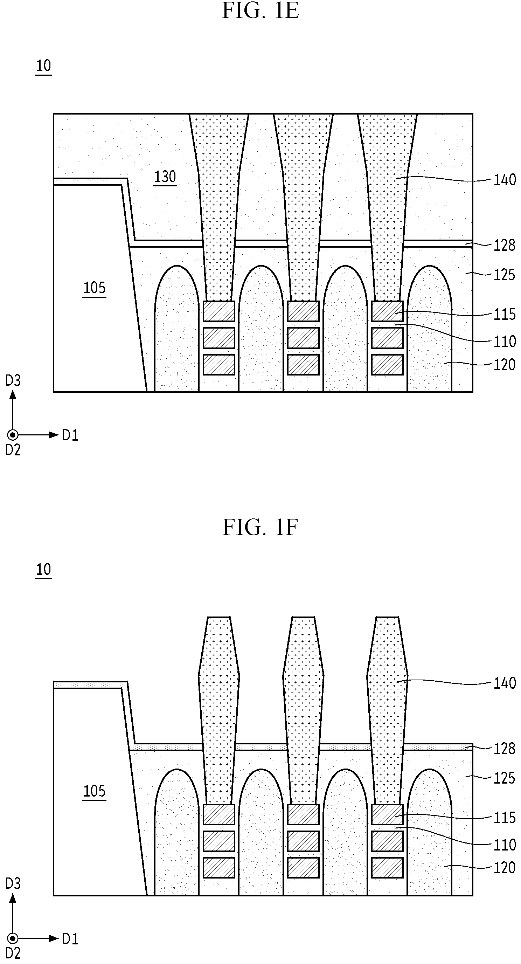

Referring to FIG. 1E, the remaining 2^{nd} liner 136 may be removed from the 1^{st} recesses RE1, and backside isolation structures 140 may be formed in the 1^{st} recesses RE1 to contact the top surfaces of the gate structures 115, respectively.

The remaining portion of the 2^{nd} liner 136 may be removed from the 1^{st} recesses RE1 through, for example, dry etching or wet etching prior to forming the backside isolation structure 140 in the 1^{st} recesses RE1. The backside isolation structure 140 may be formed in the 1^{st} recesses RE1 to be respectively connected to the top surface of each of the gate structures 115, for example, that of the work-function metal layer or the gate electrode thereof, to isolate at least the top surface of the gate structure 115 from backside contact structures to be formed in a later step, thereby isolating the gate structures 115 from the source/drain patterns 120 respectively to be connected to the backside contact structures in a later step.

The backside isolation structures 140 may be formed in the 1^{st} recesses RE1 through, for example, deposition of silicon oxide (SiO or SiO₂), etc. by PVD, CVD, PECVD, etc., followed by planarization on top such as chemical mechanical polishing (CMP), not being limited thereto, so that top surfaces of the backside isolation structures 140 are coplanar or horizontally aligned with the top surface of the 1^{st} masking structure 130.

As the backside isolation structure 140 is in a form buried in the frontside isolation structure 125, the backside isolation structure 140 may be referred to as a buried backside isolation (BBI) structure.

Referring to FIG. 1F, the 1^{st} masking structure 130 may be removed and top-corner rounding may be performed on the backside isolation structures 140.

The 1^{st} masking structure 130 may be removed by ashing, stripping, selective etching, etc., not being limited thereto, to expose the backside isolation structures 140 and the 1^{st} liner 128 that is formed on the top surfaces of the frontside isolation structure 125 and the STI structure 105. Thus, each of the backside isolation structures 140 may be in a form of pillar connected to the top surface of the corresponding gate structure 115 through the frontside isolation structure 125 and protruded from the top surface of the frontside isolation structure 125 in the D3 direction.

Further, top corners of the backside isolation structures 140 may be rounded by dry etching, not being limited thereto, to facilitate a patterning operation on a 2^{nd} masking structure surrounding the backside isolation structures 140 to expose bottom surfaces of the source/drain patterns 120 in a later step.

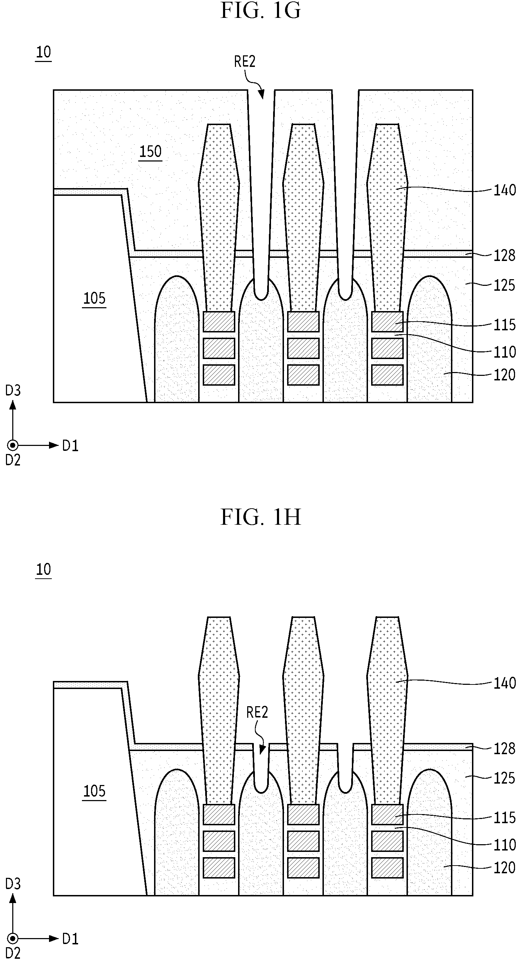

Referring to FIG. 1G, a 2^{nd} masking structure 150 may be formed to surround the backside isolation structures 140 and patterned to form 2^{nd} recesses RE2 exposing bottom surfaces of selected source/drain patterns 120 through the frontside isolation structure 125 and the 2^{nd} masking structure 150.

The 2^{nd} masking structure 150, which may be or include an SOH, may be formed through, for example, depositing a carbon-based polymer on the top surface of the frontside isolation structure 125 with the 1^{st} liner 128 thereon by PVD, CVD, PECVD, sputtering, and/or plating, not being limited thereto. The 2^{nd} masking structure 150 may passivate the backside isolation structures 140 during a patterning operation on the 2^{nd} masking structure 150 in a subsequent process. According to one or more other embodiments, a different type of material may be used to form the 2^{nd} masking structure 150.

After formation of the 2^{nd} masking structure 150 on the top surface of the frontside isolation structure 125 with the 1^{st} liner 128 thereon, the 2^{nd} masking structure 150 and the frontside isolation structure 125 therebelow with the 1^{st} liner 128 thereon may be vertically patterned to form the 2^{nd} recesses RE2 therein at positions below which the selected source/drain patterns 120 are formed. This patterning operation on the 2^{nd} masking structure 150 may be performed based on another hard mask layer through, for example, dry etching or wet etching, not being limited thereto. At this time, a top portion of each of the selected source/drain patterns 120 may also be etched. Here, it is understood that the top portion of the selected source/drain pattern 120 may refer to a bottom portion thereof before and after the manufacturing process described herein in reference to FIGS. 1A to 1J as mentioned earlier.

Referring to FIG. 1H, the 2^{nd} masking structure 150 may be removed to expose the backside isolation structures 140, and also expose the selected source/drain patterns 120 through the 2^{nd} recesses RE2.

The 2^{nd} masking structure 150 may be removed by ashing, stripping, selective etching, etc., not being limited thereto, to expose the backside isolation structures 140 and the 1^{st} liner 128 again, and also expose the top surface of each of the selected source/drain patterns 120 through the 2^{nd} recess RE2 remaining after the removal of the 2^{nd} masking structure 150. Here, the backside isolation structures 140 may take a pillar form protruded from the top surface of the frontside isolation structure 125 with the 1^{st} liner 128 thereon.

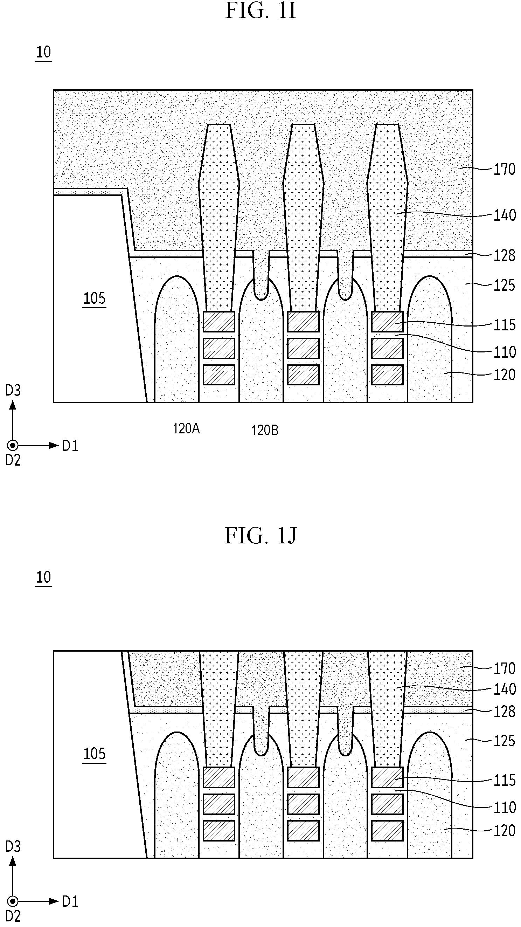

Referring to FIG. 1I, a backside contact structure 170 may be formed on a top surface of the intermediate semiconductor device 10 with the 2^{nd} recesses RE2 thereon so that the backside contact structure 170 can be connected to the selected source/drain patterns 120 through the 2^{nd} recesses RE2.

The backside contact structure 170 may be formed through, for example, deposition of a metal, such as molybdenum (Mo), ruthenium (Ru), tungsten (W), cobalt (Co), aluminum (Al), and copper (Cu), etc. or a metal alloy thereof on the top surface of the frontside isolation structure 125 with the 1^{st} liner 128 thereon so that the metal or metal alloy may also fill in the 2^{nd} recesses RE2 to be connected to the selected source/drain patterns 120. Thus, while a portion of the backside contact structure 170 may be formed in the 2^{nd} recesses RE2 in the frontside isolation structure 125, the other portion of the backside contact structure 170 may be formed on the top surface of the frontside isolation structure 125 with the 1^{st} liner 128 thereon. The deposition process applied in this step may be PVD, CVD, PECVD, etc. or a combination thereof, not being limited thereto.

Here, the backside contact structure 170 may be formed on the top surface of the frontside isolation structure 125 with the 1^{st} liner 128 thereon to surround the backside isolation structures 140 each of which is in a pillar shape. For example, the backside contact structure 170 may be formed even vertically above a source/drain pattern 120A, in the D3 direction, which is connected to a source/drain pattern 120B, on which the backside contact structure 170 is formed, through the channel structure 110 therebetween but is not connected to the backside contact structure 170. Thus, the backside isolation structure 140 may not be formed vertically above this source/drain pattern 120A not connected to the backside contact structure 170.

Between at least each of the selected source/drain patterns 120 and the backside contact structure 170 may be formed a silicide layer such as nickel silicide (NiSi), cobalt silicide (CoSi₂), or titanium silicide (TiSi₂), through an annealing process, not being limited thereto, to improve conductivity and minimize a contact resistance between the selected source/drain pattern 120 and the backside contact structure 170.

Referring to FIG. 1J, the intermediate semiconductor device 10 obtained in the previous step (FIG. 1I) may be planarized on top.

The backside contact structures 170 and the backside isolation structures 140 obtained in the previous step (FIG. 1I) may be planarized through, for example, CMP, not being limited thereto, such that top surfaces of the backside contact structures 170 may be coplanar or horizontally aligned with top surfaces the backside isolation structures 140 and the top surface of the STI structure 105. Further, an additional process such as connecting the backside contact structures 170 with other circuit elements may be performed.

It is acknowledged from the above embodiments that the intermediate semiconductor device 10 shown in FIG. 1J is formed through a process that deviates from a related-art approach in which a backside contact structure is formed in a backside isolation structure which is formed earlier than the backside contact structure by replacing a substrate of the intermediate semiconductor device. As described above, the backside contact structures 170 in the intermediate semiconductor device 10 may be obtained by forming the 1^{st} masking structure 130 to replace the substrate, patterning the 1^{st} masking structure 130 to form the 1^{st} recesses RE1 in the frontside isolation structure 125 and the 1^{st} masking structure 130, forming the backside isolation structures 140 in the 1^{st} recesses RE1, removing the 1^{st} masking structure 130, forming the 2^{nd} masking structure 150 surrounding the backside isolation structures 140, patterning the 2^{nd} masking structure 150 to form the 2^{nd} recesses RE2 in the frontside isolation structure 125 and the 2^{nd} masking structure 150, and then, forming the backside contact structures 170 in the 2^{nd} recesses RE2.

Thus, the intermediate semiconductor device 10 may take a form in which the backside isolation structures 140 are buried in and surrounded by the backside contact structure 170 having a shape of pillar therein, while the related-art intermediate semiconductor device takes a form in which a backside contact structure having a shape of pillar is buried in and surrounded by a backside isolation structure. For example, an entire side surface of a portion of each of the backside isolation structures 140 protruded from the top surface of the frontside isolation structure 125 with the 1^{st} liner 128 thereon may be surrounded by the backside contact structure 170.

Referring to FIG. 1K, the intermediate semiconductor device 10 obtained in the previous step (FIG. 1J) may be flipped upside down for a subsequent process.

As shown in FIG. 1K, the intermediate semiconductor device 10 shown in FIG. 1J may be flipped or turned upside down for a subsequent process. Thus, the top surface and the bottom surface of the structural elements of the intermediate semiconductor devices 10 shown in FIGS. 1A-1J become bottom surfaces and top surfaces thereof, respectively.

Here, the backside contact structure 170 may include a 1^{st} portion with the 1^{st} liner 128 thereon which surrounds an entire lower side surface of the backside isolation structures 140 and a 2^{nd} portion in a pillar form protruded from a top surface of the 1^{st} portion with the 1^{st} liner 128 thereon and connected to the selected source/drain patterns 120.

Through the above process described in ref to FIGS. 1A-1K, the backside contact structures 170, which may be referred to as direct backside contact structures (DBCs), may be formed to contact the selected source/drain patterns 120 to connect these active regions of the semiconductor device with other circuit elements such as backside power rails for power delivery or other metal lines for signal routing. However, the formation of the backside contact structures 170 in the above manner may be challenging because of at least a high device density and a high aspect ratio of the intermediate semiconductor device 10. Thus, there is a risk of at least one of the backside contact structures 170 being misaligned with a corresponding source/drain pattern 120, resulting in an unintended short circuit between the backside contact structure 170 and the gate structure 115 as described below.

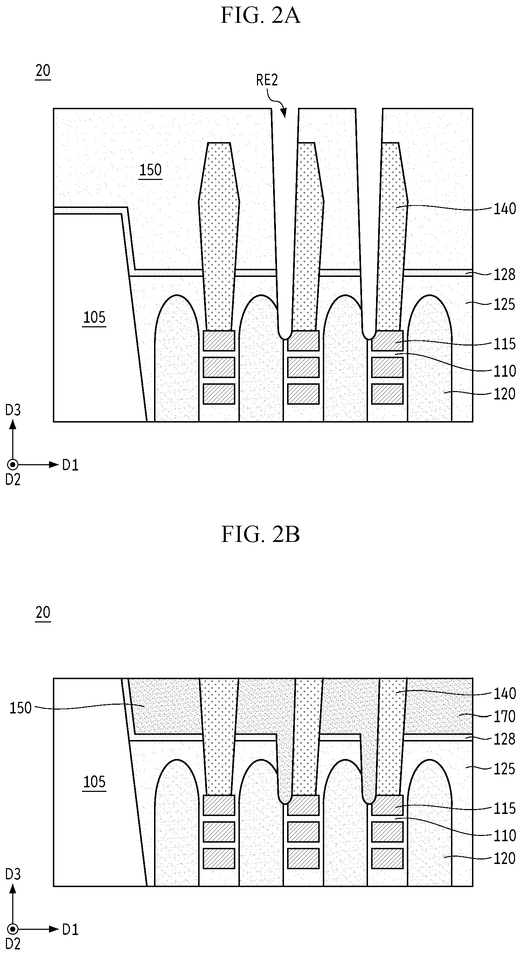

FIG. 2A illustrates an intermediate semiconductor device in which a recess to form a backside contact structure therein is misaligned with a selected source/drain pattern, and FIG. 2B illustrates the intermediate semiconductor device in which a backside contact structure is connected to a gate structure as well as the selected source/drain pattern, according to one or more embodiments.

Referring to FIG. 2A corresponding to FIG. 1G, an intermediate semiconductor device 20 may be formed such that the 2^{nd} recesses RE2 are patterned at incorrect positions through the 2^{nd} masking structure 150, the 1^{st} liner 128, and the frontside isolation structure 125, and thus, the misaligned 2^{nd} recesses RE2 may expose not only the selected source/drain patterns 120 but also the adjacent gate structures 115, for example, the work-function metal layer or the gate electrode of each of the gate structures 115 adjacent to the selected source/drain patterns 120.

The misaligned 2^{nd} recesses RE2 may be formed because of a poor initial overlay of the 2^{nd} recesses RE2 on a top surface of the 2^{nd} masking structure 150. As an etchant to pattern the 2^{nd} masking structure 150 to form the 2^{nd} recesses RE2 is applied based on the poor initial overlay of the 2^{nd} recesses RE2, the etchant may pattern even a side portion of the backside isolation structure 140, and further, a portion of the frontside isolation structure 125 therebelow and a portion of the gate structure 115 therebelow to expose the gate structure 115, for example, the work-function metal layer or the gate electrode thereof.

Referring to FIG. 2B corresponding to FIG. 1J, because of the misalignment (or poor overlay) of the 2^{nd} recesses RE2 with the selected source/drain patterns 120 in the previous step (FIG. 2A), the backside contact structures 170 may be formed in the misaligned 2^{nd} recesses RE2 so that the backside contact structures 170 contacting the selected source/drain patterns 120 may also contact the adjacent gate structures 115, for example, the work-function metal layer or the gate electrode thereof, which can cause an unintended short circuit therebetween to fail functions of a semiconductor device formed from the intermediate semiconductor device 20.

The following embodiments address the above-described risk of a short circuit that may occur in formation of backside contact structures for a semiconductor device.

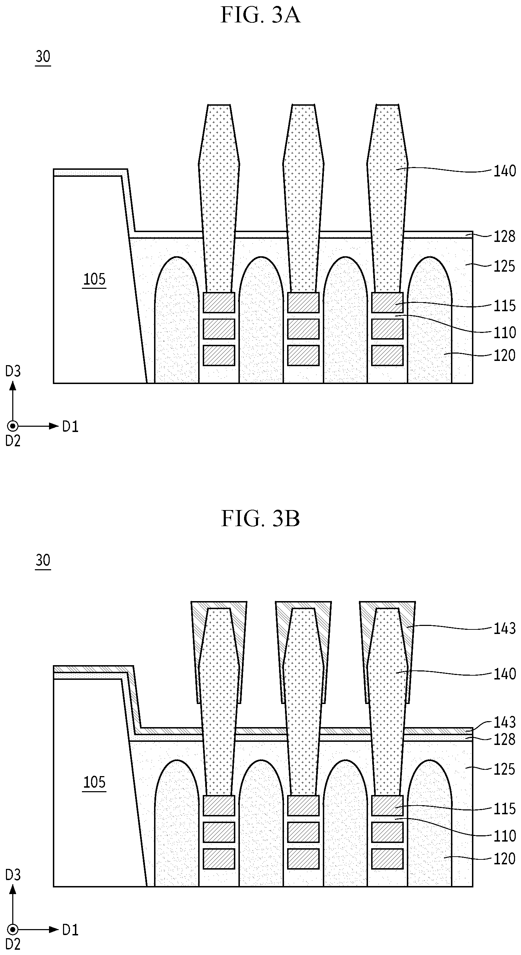

FIGS. 3A to 3H illustrate a method of manufacturing a semiconductor device including a backside contact structure formed based on a self-aligned patterning operation, according to one or more embodiments.

Referring to FIG. 3A, an intermediate semiconductor device 30 is provided in an upside-down form after the backside isolation structures 140, of which top-corner rounding is performed, are formed to be connected to gate structures 115, respectively.

The intermediate semiconductor device 30 shown in FIG. 3A may be obtained in the same manner as the intermediate semiconductor device 10 in FIG. 1F, which is described in detail with reference to FIGS. 1A-1F. Therefore, while a duplicate description of the formation process for the intermediate semiconductor device 30 may be omitted herein, the same reference numbers may be used to describe the same structural elements.

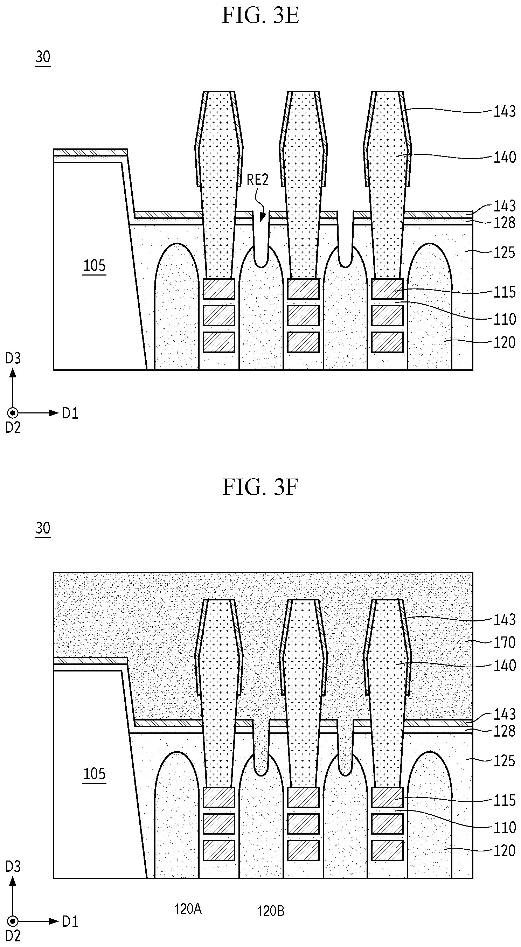

It is to be understood here that, as the intermediate semiconductor devices 30 shown in FIGS. 3A-3G are in an upside-down form, a top surface (portion) and a bottom surface (portion) of each of structural elements thereof may respectively refer to a bottom surface (portion) and a top surface (portion) of the structural element thereof before they are flipped or turned upside down or after they are completed as a semiconductor device shown in FIG. 3F.

Like the intermediate semiconductor device 10 shown in FIG. 1F, the intermediate semiconductor device 30 shown in FIG. 3A may also include the backside isolation structures 140 in a pillar form connected to the respective gate structures 115 through the frontside isolation structure 125.

Referring to FIG. 3B, an alignment spacer layer 143 may be formed on an upper portion of each of the backside isolation structures 140 and the top surface of the frontside isolation structure 125 with the 1^{st} liner 128 thereon.

The alignment spacer layer 143 may be formed on the upper portion of each backside isolation structure 140 through, for example, deposition of silicon nitride (SiN, Si₃N₄, etc.) by CVD, ALD, PECVD, PEALD, a combination thereof, not being limited thereto, on a top surface and an upper side surface of the backside isolation structure 140.

For example, the alignment spacer layer 143 may be formed to entirely enclose the upper portion, including the top surface and the upper side surface, of each of the backside isolation structures 140. Further, the alignment spacer layer 143 may enclose the upper portion of each of the backside isolation structures 140 such that a thickness of the alignment spacer layer 143 on a side surface of the backside isolation structure 140 may decrease from a level of the top surface thereof downward in the D3 direction. Still, a bottom portion of the alignment spacer layer 143 may be formed on the side surface of the backside isolation structure 140 at a level lower than a level of the top surface of the STI structure 105 in the D3 direction.

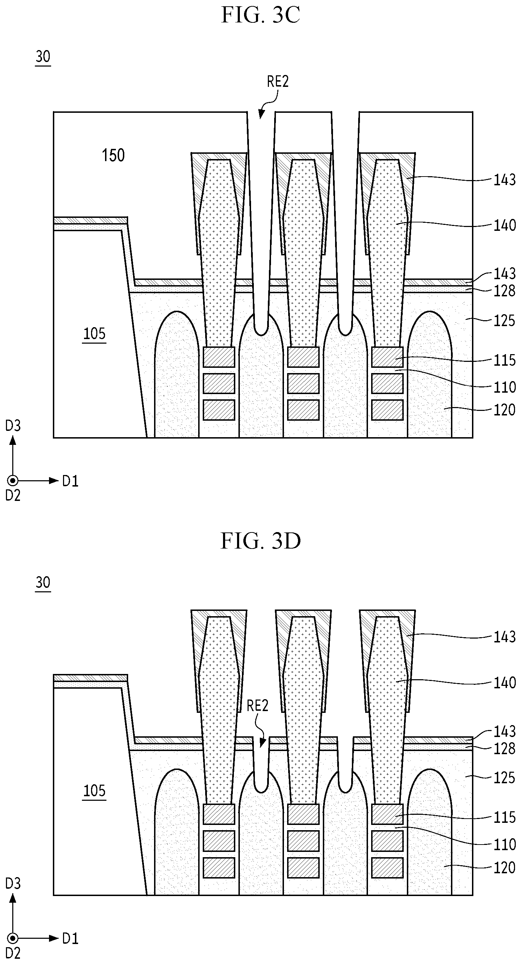

The alignment spacer layer 143 including silicon nitride is used in a later step (FIG. 3C) to facilitate self-aligned patterning of 2^{nd} recesses in a 2^{nd} masking structure.

As the alignment spacer layer 143 is selectively deposited in this manner, a top surface of the 1^{st} liner 128 on the top surfaces of the frontside isolation structure 125 and the STI structure 105 may also be at least partially covered by the alignment spacer layer 143. Further, as the alignment spacer layer 143 is formed of a material, such as silicon nitride, different from that forming the backside isolation structure 140, and formed on the backside isolation structure 140 which is already formed, a connection surface or interface may be formed between the two structures.

Referring to FIG. 3C, a 2^{nd} masking structure 150 may be formed to surround the backside isolation structures 140 with the respective alignment spacer layers 143 thereon and patterned to form 2^{nd} recesses RE2 exposing bottom surfaces of selected source/drain patterns 120.

The 2^{nd} masking structure 150, which may be or include an SOH, may be formed through, for example, depositing a carbon-based polymer on the top surface of the frontside isolation structure 125 with the 1^{st} liner 128 thereon by PVD, CVD, PECVD, sputtering, and/or plating, not being limited thereto. The 2^{nd} masking structure 150 may be used to mask the backside isolation structures 140 during a patterning operation on the 2^{nd} masking structure 150 in a subsequent process. According to one or more other embodiments, a different type of material may be used to form the 2^{nd} masking structure 150.

After formation of the 2^{nd} masking structure 150 on the top surface of the frontside isolation structure 125 with the 1^{st} liner 128 thereon, the 2^{nd} masking structure 150 and the frontside isolation structure 125 therebelow with the 1^{st} liner 128 thereon may be vertically patterned to form the 2^{nd} recesses RE2 therein at positions below which the selected source/drain patterns 120 are formed. This patterning operation on the 2^{nd} masking structure 150 may be performed based on another hard mask layer through, for example, dry etching or wet etching, not being limited thereto, which is self-aligned based on the backside isolation structures 140 with the respective alignment spacer layers 143 thereon.

The self-aligned patterning of the 2^{nd} masking structure 150 may be facilitated due to the alignment spacer layers 143 which guide flow of an etchant through a portion of the 2^{nd} masking structure 150 between the alignment spacer layers 143 formed on respective upper side surfaces of two adjacent backside isolation structures 140 so that the 2^{nd} recesses RE2 formed by the self-aligned patterning against the silicon nitride of the alignment spacer layers 143 can be aligned with the selected source/drain patterns 120, respectively, in the frontside isolation structure 125.

For example, oxygen (O₂) plasma or a mixture of oxygen and other reactive gases (e.g., O₂/CF₄ or O₂/CHF₃) may be used as a dry-etching etchant to pattern the carbon-based polymer forming the 2^{nd} masking structure 150 without attacking the alignment spacer layers 143 to expose the top surface of each of the selected source/drain patterns 120. As another example, a sulfuric acid and hydrogen peroxide mixture may be used as a wet-etching etchant for the same purposes. The disclosure is not limited to the foregoing patterning operation. According to one or more other embodiments, different patterning operations using different etchants may be used as long as self-aligned patterning can be enabled based on the alignment spacer layers 143 formed of silicon nitride. However, according to one or more other embodiments, the alignment spacer layer 143 may be formed of a different material(s) that enables self-aligned selective patterning of the 2^{nd} masking structure 150 formed of, e.g., SOH.

Due to the self-aligned patterning, the 2^{nd} recess RE2 may be precisely aligned with the selected source/drain patterns 120 to expose the bottom surfaces of the selected source/drain patterns 120 without exposing the adjacent gate structures 115, for example, the work-function metal layer or the gate electrode thereof, formed at sides of the selected source/drain patterns 120.

At this time, a top portion of each of the selected source/drain patterns 120 may also be etched. Here, it is understood that the top portion of the selected source/drain pattern 120 may refer to a bottom portion thereof before and after the manufacturing process described herein in reference to FIGS. 3A to 3G as mentioned earlier.

Referring to FIG. 3D, the 2^{nd} masking structure 150 may be removed to expose the backside isolation structures 140 with the alignment spacer layers 143 thereon, and also expose the selected source/drain patterns 120 through the 2^{nd} recesses RE2.

The 2^{nd} masking structure 150 may be removed by ashing, stripping, selective etching, etc., not being limited thereto, to expose the backside isolation structures 140 with the alignment spacer layer 143 thereon and the 1^{st} liner 128 again. The removal of the 2^{nd} masking structure 150 may also expose the top surface of each of the selected source/drain patterns 120 through the 2^{nd} recess RE2. Here, the backside isolation structures 140 with the respective alignment spacer layers 143 may take a pillar form protruded from the top surface of the frontside isolation structure 125 with the 1^{st} liner 128 and the alignment spacer layer 143 thereon.

Referring to FIG. 3E, top-corner rounding may be performed on the backside isolation structures 140 with the alignment spacer layers 143 thereon.

The top-corner rounding on the backside isolation structures 140 in this step may be performed such that a portion of the alignment spacer layer 143 formed on the top surface of the backside isolation structure 140 may be removed and another portion of the alignment spacer layer 143 formed on the upper side surface of the backside isolation structure 140 may be rounded to facilitate deposition of a metal or metal alloy as a backside contact structure into the 2^{nd} recesses RE2 in a next step. For example, when the metal or metal alloy is deposited from top on the intermediate semiconductor device 30 obtained in the previous step, the top-corner-rounded backside isolation structures 140 with the alignment spacer layers 143 thereon may facilitate flow of the metal or metal alloy downward through side surfaces of the backside isolation structures 140 with the alignment spacer layers 143 thereon.

Referring to FIG. 3F, a backside contact structure 170 may be formed on a top surface of the intermediate semiconductor device 30 with the 2^{nd} recesses RE2 thereon so that the backside contact structure 170 can be connected to the selected source/drain patterns 120 through the 2^{nd} recesses RE2.

The backside contact structure 170 may be formed through, for example, deposition of a metal such as molybdenum (Mo), ruthenium (Ru), tungsten (W), cobalt (Co), aluminum (Al), copper (Cu), etc. or a metal alloy thereof, on the top surface of the frontside isolation structure 125 with the 1^{st} liner 128 and the alignment spacer layer 143 thereon so that the metal or metal alloy may also fill in the 2^{nd} recesses RE2 to be connected to the selected source/drain patterns 120. Thus, while a portion of the backside contact structure 170 may be formed in the 2^{nd} recesses RE2 in the frontside isolation structure 125, the other portion of the backside contact structure 170 may be formed on the top surface of the frontside isolation structure 125 with the 1^{st} liner 128 and the alignment spacer layer 143 thereon. The deposition process applied in this step may be PVD, CVD, PECVD, etc. or a combination thereof, not being limited thereto. By the deposition operation in this step, the alignment spacer layer 143 on the upper side surface of each of the backside isolation structure 140 may contact the backside contact structure 170.

Here, the backside contact structure 170 may be formed on the top surface of the frontside isolation structure 125 with the 1^{st} liner 128 and the alignment spacer layer 143 thereon to surround the backside isolation structures 140. For example, the backside contact structure 170 may be formed even vertically above a source/drain pattern 120A, in the D3 direction, which is connected to a source/drain pattern 120B, on which the backside contact structure 170 is formed, through the channel structure 110 therebetween but is not connected to the backside contact structure 170. Thus, the backside isolation structure 140 may not be formed vertically above this source/drain pattern 120A not connected to the backside contact structure 170.

Between at least each of the selected source/drain patterns 120 and the backside contact structure 170 may be formed a silicide layer such as nickel silicide (NiSi), cobalt silicide (CoSi₂), or titanium silicide (TiSi₂), through an annealing process, not being limited thereto, to improve conductivity and minimize a contact resistance between the selected source/drain pattern 120 and the backside contact structure 170.

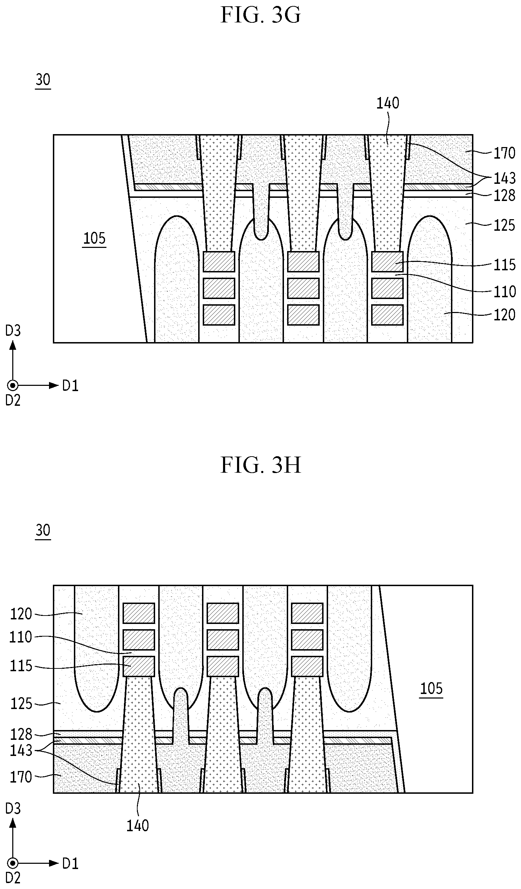

Referring to FIG. 3G, the intermediate semiconductor device 30 obtained in the previous step (FIG. 3F) may be planarized on top.

The backside isolation structures 140 with the alignment spacer layers 143 thereon and the backside contact structures 170 obtained in the previous step (FIG. 3F) may be planarized through, for example, CMP, not being limited thereto, such that top surfaces of the backside contact structures 170 may be coplanar or horizontally aligned with top surfaces the backside isolation structures 140 with the alignment spacer layers 143 thereon and the top surface of the STI structure 105. Further, an additional process such as connecting the backside contact structures 170 with other circuit elements may be performed.

At this time, at least a portion of the alignment spacer layer 143 may still remain on the upper side surface of each of the backside isolation structure 140 as the bottom portion of the alignment spacer layer 143 may have been formed at the level below the top surface of the STI structure 105 as described earlier in reference to FIG. 3B. Further, the alignment spacer layer 143 may also be formed on the top surface of the frontside isolation structure 125 with the 1^{st} liner 128 thereon. For example, the alignment spacer layer 143 may be formed between the backside contact structure 170 and the top surface of the frontside isolation structure 125 with the 1^{st} liner 128 therebetween.

It is acknowledged from the above embodiments that the intermediate semiconductor device 30 shown in FIG. 3G is formed through a process that deviates from a related-art approach in which a backside contact structure is formed in a backside isolation structure which is formed earlier than the backside contact structure by replacing a substrate of the intermediate semiconductor device. As described above, the backside contact structures 170 in the intermediate semiconductor device 30 may be obtained by forming the 1^{st} masking structure 130 to replace the substrate, patterning the 1^{st} masking structure 130 to form the 1^{st} recesses RE1 in the frontside isolation structure 125 and the 1^{st} masking structure 130, forming the backside isolation structures 140 in the 1^{st} recesses RE1, removing the 1^{st} masking structure 130, forming the alignment spacer layers 143 on the backside isolation structures 140, forming the 2^{nd} masking structure 150 surrounding the backside isolation structures 140 with the alignment spacer layers 143 thereon, patterning the 2^{nd} masking structure 150 to form the 2^{nd} recesses RE2 in the frontside isolation structure 125 and the 2^{nd} masking structure 150, and then, forming the backside contact structures 170 in the 2^{nd} recesses RE2.

Thus, like the intermediate semiconductor device 10 as shown in FIG. 1J, the intermediate semiconductor device 30 may take a form in which the backside isolation structures 140 with the alignment spacer layers 143 thereon are buried in and surrounded by the backside contact structure 170 having a shape of pillar therein, while the related-art intermediate semiconductor device takes a form in which a backside contact structure having a pillar shape is buried in and surrounded by a backside isolation structure. For example, an entire side surface of a portion of each of the backside isolation structures 140 with the respective alignment spacer layers 143 thereon protruded from the top surface of the frontside isolation structure 125 with the 1^{st} liner 128 and the alignment spacer layer 143 thereon may be surrounded by the backside contact structure 170.

Referring to FIG. 3H, the intermediate semiconductor device 30 obtained in the previous step (FIG. 3G) may be flipped upside down for a subsequent process.

As shown in FIG. 3H, the intermediate semiconductor device 30 shown in FIG. 3G may be flipped or turned upside down for a subsequent process. Thus, the top surface and the bottom surface of the structural elements of the intermediate semiconductor devices 30 shown in FIGS. 3A-3G become bottom surfaces and top surfaces thereof, respectively.

Here, the backside contact structure 170 may include a 1^{st} portion with the 1^{st} liner 128 and the alignment spacer layer 143 thereon which surrounds an entire lower side surface of the backside isolation structures 140 and a 2^{nd} portion in a pillar form protruded from a top surface of the 1^{st} portion with the 1^{st} liner 128 and the alignment spacer layer 143 thereon and connected to the selected source/drain patterns 120.

Through the above process described in ref to FIGS. 3A-3H, the backside contact structures 170 which may be referred to as direct backside contact structures (DBCs) may be formed to contact the selected source/drain patterns 120 to connect these active regions of the semiconductor device with other circuit elements such as backside power rails for power delivery or other metal lines for signal routing.

Here, as described above, the alignment spacer layer 143 formed on an upper side surface of each backside isolation structure 140, now a lower side surface thereof in FIG. 3H, may be used to enable formation of the self-aligned the 2^{nd} recess RE2 to be aligned with the selected source/drain pattern 120. Thus, the subsequent process of forming the backside contact structure 170 in the 2^{nd} recess RE2 may be able to avoid the risk of a short circuit between the selected source/drain pattern 120 and the adjacent gate structure 115 that may occur in the semiconductor device shown in FIG. 2B.

In the meantime, the alignment spacer layer 143 may enable formation of the self-aligned the 2^{nd} recess RE2 to be aligned with the selected source/drain pattern 120 even when the 2^{nd} recess RE2 is poorly overlaid on a top surface of the 2^{nd} masking structure 150, as described below.

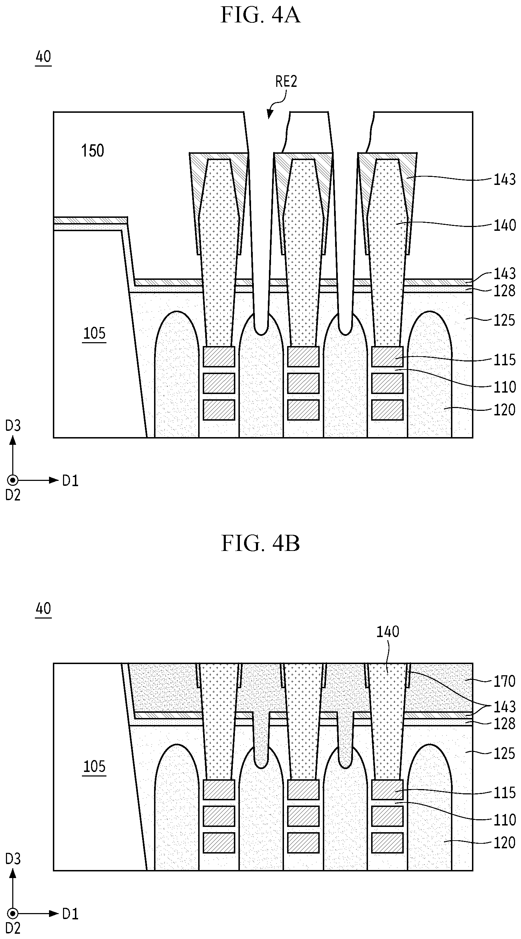

FIG. 4A illustrates an intermediate semiconductor device in which a recess to form a backside contact structure therein is misaligned with a selected source/drain pattern, and FIG. 4B illustrates the intermediate semiconductor device in which a backside contact structure is connected to only the selected source/drain pattern without being connected to an adjacent gate structure, according to one or more embodiments.

Referring to FIG. 4A corresponding to FIG. 2A, an intermediate semiconductor device 40 may be formed such that the 2^{nd} recesses RE2 are patterned based on a poor overlay on the top surface of the 2^{nd} masking structure 150 as in FIG. 2A, and thus, an upper portion of each of the 2^{nd} recesses RE2 may even expose a top surface of the alignment spacer layer 143 formed on the backside isolation structure 140. However, an etchant used to pattern the 2^{nd} masking structure 150 may selectively etch only the 2^{nd} masking structure 150 without attacking the backside isolation structure 140 with the alignment spacer layer 143 thereon by being guided by the alignment spacer layer 143. Thus, a lower portion of the 2^{nd} recess RE2 may be formed to be aligned with the selected source/drain pattern 120 so that only the selected source/drain pattern 120 is exposed through the 2^{nd} recess RE2, without exposing the adjacent gate structures 115, for example, the work-function metal layer or the gate electrode thereof, formed at sides of the selected source/drain pattern 120.

Referring to FIG. 4B corresponding to FIG. 2B, regardless of the poor overlay and misalignment of the 2^{nd} recesses RE2 on the top surface of the 2^{nd} masking structure 150, the lower portion of each of the self-aligned 2^{nd} recesses RE2 may enable formation of the backside contact structures 170 to contact only the selected source/drain patterns 120 without the risk of a short circuit with the adjacent gate structures 115.

Thus, the backside isolation structures 140 with the alignment spacer layers 143 thereon may address the misalignment between the backside contact structures 170 and the selected source/drain patterns 120, respectively, shown in FIGS. 2A and 2B.

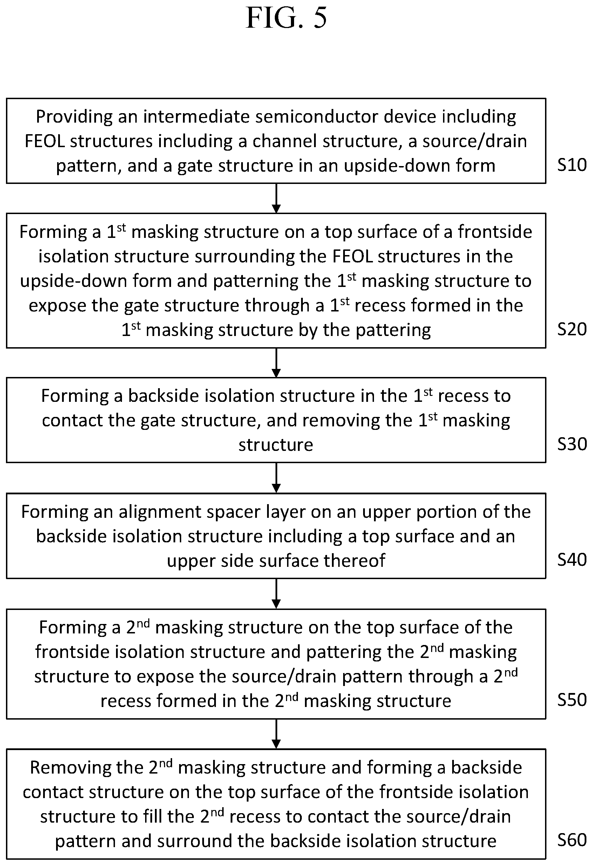

FIG. 5 illustrates a flowchart of a method of manufacturing a semiconductor device including a backside contact structure formed based on a self-aligned patterning operation in reference to FIGS. 3A-3H, according to one or more embodiments.

Structural elements described herein with respect to the flowchart may be the same or correspond to those described above in reference to FIGS. 3A-3H, and thus, duplicate descriptions thereof may be omitted herein.

In step S10, an intermediate semiconductor device including FEOL structures such as a channel structure, a source/drain pattern on the channel structure, and a gate structure surrounding the channel structure may be provided in an upside-down form. In the intermediate semiconductor device, the FEOL structures may be surrounded by an frontside isolation structure of which a top surface faces upward in the D3 direction as the intermediate semiconductor device is provided in the upside-down form.

In step S20, a 1^{st} masking structure may be formed on a top surface of the frontside isolation structure in the upside-down form and patterned to expose the gate structure through a 1^{st} recess formed in the 1^{st} masking structure by the patterning operation in this step. The 1^{st} masking structure may be or include a spin-on-hard mask (SOH) which may be formed of a carbon-based polymer or a silicon-containing polymer. The gate structure exposed through the 1^{st} recess may be at least a work-function metal layer or a gate electrode of the gate structure.

In step S30, a backside isolation structure may be formed in the 1^{st} recess in the 1^{st} masking structure to contact the gate structure, and the 1^{st} masking structure may be removed from the intermediate semiconductor device leaving the backside isolation structure in a pillar form protruded from the top surface of the frontside isolation structure in the upside-down form.

In step S40, an alignment spacer layer may be formed on an upper portion of the backside isolation structure including a top surface and an upper side surface thereof. The alignment spacer layer may include a material, for example, silicon nitride, different from that of the backside isolation structure which may be silicon oxide. Prior to the formation of the alignment spacer layer, the upper portion of the backside isolation structure may be rounded to facilitate the formation of the alignment spacer layer thereon.

In step S50, a 2^{nd} masking structure may be formed on the top surface of the frontside isolation structure and patterned to expose the source/drain pattern through a 2^{nd} recess formed in the 2^{nd} masking structure by the patterning operation in this step. Here, the patterning of the 2^{nd} masking structure may be performed in a self-aligning manner due to the alignment spacer layer formed on the upper portion of the backside isolation structure. The 2^{nd} masking structure may also be or include an SOH, which may be formed of a carbon-based polymer or a silicon-containing polymer, like the 1^{st} masking structure.

In step S60, the 2^{nd} masking structure may be removed, and a backside contact structure may be formed on the top surface of the frontside isolation structure to be filled in the 2^{nd} recess to contact the source/drain pattern and surround the backside isolation structure in the pillar form protruded from the top surface of the frontside isolation structure. Prior to the formation of the backside contact structure, the upper portion of the backside isolation structure with the alignment spacer layer may be rounded to facilitate the formation of the backside contact structure.

In the above embodiments, the transistor structures formed in the intermediate semiconductor devices 10-40 are described as nanosheet transistors. However, the disclosure is not limited thereto, and may be applied to an intermediate semiconductor device including different types of field-effect transistor such as fin field-effect transistor (FinFET), forksheet transistor, vertical field-effect transistor (VFET), etc., not being limited thereto.

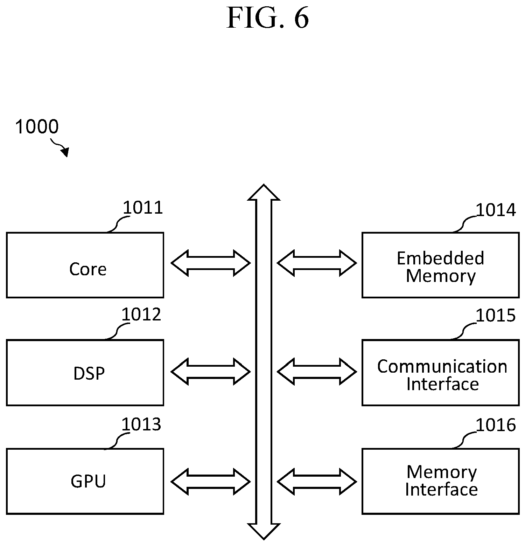

FIG. 6 is a schematic block diagram illustrating an electronic device including at least one semiconductor device formed based on at least one of the semiconductor devices 10 and 30 shown in FIGS. 1K and 3H, respectively, according to one or more embodiments.

Referring to FIG. 6, a system-on-chip (SoC) 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (RAM) (DRAM), a flash memory, etc.

At least one of the core 1011, the DSP 1012, the GPU 1013, and/or the embedded memory 1014 may include at least one of the semiconductor devices described above.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a channel structure;
a gate structure on the channel structure;
a backside isolation structure on the gate structure;
an alignment spacer layer on a lower side surface of the backside isolation structure, the alignment spacer layer comprising a material different from a material of the backside isolation structure;
a source/drain pattern on the channel structure; and
a backside contact structure on the source/drain pattern.

2. The semiconductor device of claim 1, wherein an interface or a connection surface is provided between the alignment spacer layer and the backside isolation structure.

3. The semiconductor device of claim 1 or 2, wherein the backside isolation structure comprises silicon oxide, and the alignment spacer layer comprises silicon nitride.

4. The semiconductor device of any one of claims 1 to 3, wherein the backside isolation structure is in a pillar form buried in the backside contact structure.

5. The semiconductor device of any one of claims 1 to 4, further comprising a shallow trench isolation, STI, structure at a side of the backside contact structure,
wherein a top portion of the alignment spacer layer on the lower side surface of the backside isolation structure is at a level above a bottom surface of the STI structure.

6. The semiconductor device of any one of clams 1 to 5, further comprising a frontside isolation structure surrounding the source/drain pattern,
wherein the alignment spacer layer is formed between the frontside isolation structure and the backside contact structure.

7. The semiconductor device of any one of claims 1 to 6, further comprising another source/drain pattern connected to the source/drain pattern through the channel structure but not connected to any backside contact structure,
wherein a material forming the backside contact structure is formed at a side of the backside isolation structure, below the other source/drain pattern.

8. The semiconductor device of claim 7, wherein the backside isolation structure is not formed below the other source/drain pattern.

9. The semiconductor device of any one of claims 1 to 8, wherein the backside isolation structure comprises a material containing oxide, and the alignment spacer layer comprises a material containing nitride.

10. The semiconductor device of any one of claims 1 to 9, wherein the gate structure comprises a gate dielectric layer, a work-function metal layer, and a gate electrode, and
wherein the backside isolation structure is connected to the work-function metal layer or the gate electrode.

11. A semiconductor device comprising:
a channel structure;
a gate structure on the channel structure;
a backside isolation structure on the gate structure;
a 1^{st} source/drain pattern and a 2^{nd} source/drain pattern on the channel structure; and
a backside contact structure of which a 1^{st} portion is provided at a 1^{st} side of the backside isolation structure, below the 1^{st} source/drain pattern,
wherein a 2^{nd} portion of the backside contact structure is provided at a 2^{nd} side, opposite the 1^{st} side, of the backside isolation structure, below the 2^{nd} source/drain pattern, and
wherein the 2^{nd} source/drain pattern is not connected to another backside contact structure.

12. The semiconductor device of claim 11, wherein an entire lower side surface of the backside isolation structure at a side of the backside contact structure below a level of a bottom surface of the source/drain pattern is surrounded by the backside contact structure.

13. The semiconductor device of claim 11 or 12, wherein an alignment spacer layer is formed at a lower side surface of the backside isolation structure.

14. The semiconductor device of claim 13, wherein the lower side surface of the backside isolation structure with the alignment spacer layer thereon is surrounded by the backside contact structure.

15. The semiconductor device of claim 13, wherein the lower side surface of the backside isolation structure with the alignment spacer layer thereon is entirely surrounded by the backside contact structure.
